# EUROPEAN PATENT SPECIFICATION

(11) **EP 0 741 507 B1**
(45) Date of publication and mention of the grant of the patent: **11.11.1998**
(21) Application number: 96850033.0
(22) Date of filing: 14.02.1996
(51) Int. Cl.: H05K 7/20, H05K 7/06, H01L 23/36

(54) **Arrangement for integrated circuits and a method for mounting the same**
Arrangement für integrierte Kreise und Methode zur Montierung davon
Dispositif pour circuits intégrés et procédé d'installation

(30) Priority: 16.02.1995 SE 9500558
(43) Date of publication of application: 06.11.1996
(73) Proprietor: TELEFONAKTIEBOLAGET LM ERICSSON, 126 25 Stockholm (SE)
(72) Inventor: Fagerholt, Anders, 431 50 Mölndal (SE)
(74) Representative: Mossmark, Anders

(56) References cited:
- US-A- 5 297 006

## Description

### TECHNICAL FIELD:

The present invention relates to an arrangement for integrated circuits, which circuits are positioned on a support member. The support member supports connections between components in an electric circuit. The support member is provided with a device which conducts heat away from an IC circuit. The present invention also relates to a method for mounting of IC circuits on such a support member.

### BACKGROUND OF THE INVENTION:

The size of today's integrated circuits has increased, while at the same time the number of connections to the circuits also has increased. The signal speed has also increased, which means that there are greater difficulties concerning the packaging, the cooling and the connecting of the integrated circuits in a manner which is appropriate for the integrated circuit technology.

One method of creating a connection device having a higher degree of integration is to utilize so-called multichip modules (MCM).

Many different types of MCM'S have been developed for different products. What most of the types have in common is that IC chips and passive components are attached to a support member having a conductive pattern intended for the connection, and that they are connected by means of an appropriate technique, for example wire bonding, TAB (Tape Automated Bonding), "flip chip" technology, soldering or adhesion. The multichip module can be packaged in packages made of plastics, ceramics or metal, for protection against the surrounding environment and for cooling.

Different types of multichip modules exist, such as MCM-L (L = laminated), which is a multichip module based on developed PCB technique. In order to create the desired conductive pattern, a polymeric metalized material is etched, and in order to create a multi-layered structure, several plates are laminated. Holes for routes are formed before or after lamination is carried out.

Moreover, MCM-C (C = "ceramic") exists, which - in order to create the multi-layered support member - is based on different co-sintered, ceramic, multi-layered technologies. The conductive patterns are normally executed in thickfilm technique.

Furthermore, MCM-D exists, where D stands for "deposited" and where thinfilm technology is used in order to create the conductive pattern. The base material may be silicon; either ceramical or polymerical. In order to create a multi-layered structure, there are many different materials which are used as insulators, such as polyimide or silicon dioxide, or possibly silicon nitride. Combinations of different techniques also exist.

MCM modules having integrated digital and/or microwave circuits often suffer from great problems concerning cooling or handling of the power loss. An integration in an MCM module means that the IC devices come closer to each other and this increases the power loss as counted per unit area. The IC circuits themselves become larger and larger and the total losses for the IC circuit often become larger, in spite of the fact that the power loss per transistor decreases. In many applications, the clock frequency and the signal speed also increase, which also contributes to the problem concerning the cooling.

Furthermore, the size of the IC chip has increased from a few square millimetres to several hundred square millimetres, and it can now include several hundred in- and outputs. It is desirable in a typical MCM that 25-60% of the area of the support member is covered by the IC or by components. Due to large chips, a large number of connections, limitations in the number of conductive layers, pattern resolution, the size of the route and a desire to keep the module small, it is difficult to obtain enough space for the layout of all the conductive tracks.

A further problem concerning MCM modules is to be able to ensure that the included IC chips are flawless. Most often encapsuled components may be fully tested prior to the attachment thereof to the PCB. However, this is difficult to conduct with a chip that is not mounted (especially at high signal speeds and with an effective cooling). It may be difficult to carry out tests, fault-detection and repairs of the MCM, and if incorrect chips are integrated in the mounted device it may be expensive. The supply of chips which are guaranteed to function (Known Good Die, KGD) is limited, and this constitutes a problem.

Furthermore, the thermal conductivity for most of the supporting materials is much less than that of metals and other materials that are used for coolers. As regards applications having a high power consumption, there are a few strategies which are often used in order to achieve a cooling of the chips which is better than that offered by the conductive material. One solution is to arrange "thermal routes", which means that one set of holes (which are filled with conductive metal) is positioned under the integrated circuit, and that the heat which is generated is conducted down to the bottom of the support member, where a cooling element (or a chassis) can conduct the heat away to the surrounding environment. Another method is to make a hole in the supporting material itself, and to effect the attachment directly against a conductive or a nonconductive cooling element that is attached to the support member. A third alternative is to attach the chip (the integrated circuit) in such a way that it is turned upside down (e.g. "flip chip", "bump" or inverted TAB), and to attach a cooling device to the "bottom" of the chip.

Utilizing thermal routes or holes in the support member, means that there will be a very limited space for the conductive pattern which can only utilize the "paths" between the chips. The classical methods to solve this problem are to increase the size of the module, the number of conducting layers, and also to reduce the number of chips in the MCM module. However, this results in a reduced degree of integration, as well as higher costs.

From US-A-5 297 006 there is further known a three dimensional multi-chip module.

### SUMMARY OF THE INVENTION:

A main object of the present invention is to solve the above-mentioned problems, and to provide an arrangement and a method which make possible a high level of integration, while still maintaining the space for the conductive pattern.

Said object is achieved by means of an arrangement according to the present invention as defined in claim 1. Said arrangement is characterized by an electrical connecting component which includes an electrical circuit pattern and is supported by the support member and bridges the IC circuit on one of its sides. On the opposite side thereof a heat conductor is arranged in the support member.

Said object is also achieved by means of a method according to the present invention as defined in claim 7. Accordingly the IC circuit is mounted and connected to a heat conductor. Thereafter, the IC circuit is tested before the finishing connection takes place. In this regard, an electrical connecting component which bridges the IC circuit is mounted on the support member.

By means of the invention it is possible to mount IC circuits to a material having suitable heat conductivity and/or thermal coefficient of expansion - even if the carrier of the conductive pattern is not adjusted in this respect - without considerably deteriorating the possibilities of making connections. At the same time, the invention makes possible an integration of environmental protection of IC circuits, covering everything from mechanical protection to hermetic protection.

### BRIEF DESCRIPTION OF THE DRAWINGS:

The invention will be described in greater detail in the following with reference to the accompanying drawings, in which:
Fig. 1 is a cross-section of the device according to the present invention in a first embodiment,
Fig. 2 is a view from above of the device according to Fig. 1,
Fig. 3 is a cross-section of the device according to a second embodiment, whereas
Fig. 4 is a plan view of the device according to Fig. 3.

### PREFERRED EMBODIMENT:

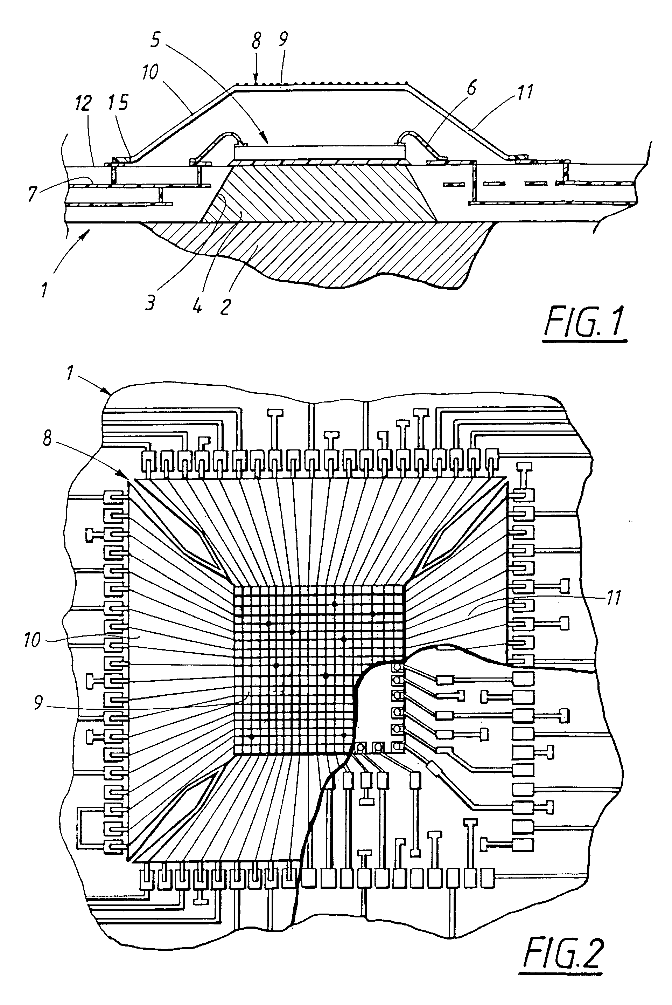

According to the first embodiment of the arrangement according to the present invention, the arrangement comprises, as is shown in Fig. 1, a support member 1, on the bottom side of which a heat absorbing device 2 is arranged. A heat conducting device 4 is positioned in a recess 3 of the support member 1. The heat conducting device is optimized with regard to the heat conductivity and/or the technical coefficient of expansion vis-à-vis the semi-conductor chip.

An integrated circuit, IC circuit 5, is positioned on the upper side of the support member 1. The integrated circuit 5 is provided with connection leads 6 which connect the electrical circuits on the integrated circuit to conductive patterns 7 on the support member 1.

The basis for the idea behind the invention is to make use of the area underneath the integrated circuit 5 (with high power loss) for cooling/matching of the coefficient of expansion, and to separate certain parts of the conductive pattern from other parts of the conductive pattern and to form a connecting component 8 which is mounted on top of the mounted IC circuit.

In this manner, the material in the connecting component 8 may be chosen and optimized without having to take into consideration its thermal conductivity. Instead, it is possible to optimize the area underneath the IC circuit 5 or the IC circuits for cooling e t c. The heat conductor 4 in the recess 3 can be constituted by a massive body in a material having excellent heat conductivity - for example a suitable metal - or it can be constituted by cooling bars or thermal routes.

The support member 1 supports components included in the electric circuit in which the IC circuit 5 or the IC circuits are included, together with the required connections. The support member may be made of an electrically insulating frame material having conductive patterns arranged in one or more layers using a conventional technique. The frame material of the support member is preferably some sort of polymeric material. The connecting component 8 can have fundamentally the same design as the support member in one or more layers with an electric insulating frame. By means of the connecting component, the conductive pattern - which otherwise would be arranged in the support member underneath the IC circuit 5 - is thus transported to a place above the IC circuit. As is apparent from the embodiment according to Fig. 1, the connecting component 8 is mechanically free from contact with the IC circuit and is supported directly by the support member 7, by means of it having a bridge-like structure, at which the conductive pattern 9 passes above the IC circuit and the connecting area on at least two side sections 10, 11, which in the first example of embodiment are inclining downwards and are supported by the upper part 12 of the support member 1. Thus, the side sections 10, 11 form support legs for the conductive pattern 9 and support a large number of conductors, as is apparent from the plan view according to Fig. 2. The side sections 10, 11 can extend around the IC circuit, thereby completely encasing the IC circuit which, due to this, becomes highly mechanically protected. The encapsulation which is obtained by this can be carried out as an electric or magnetic shielding, or solely as a physical protection. A connecting component of this kind may advantageously be executed by means of TAB-technique.

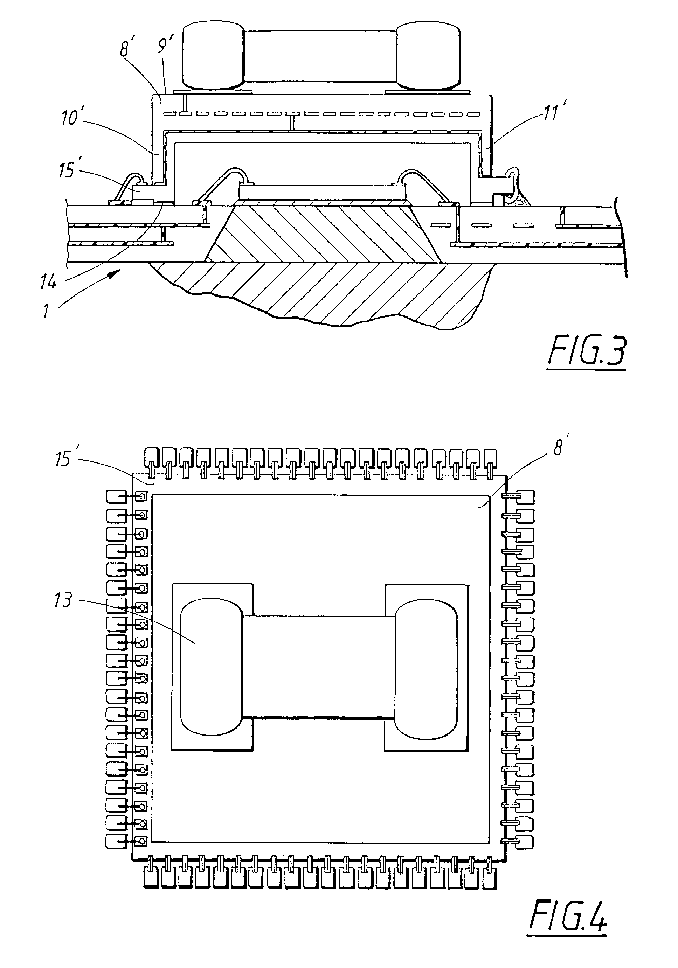

Figs. 3 and 4 show a modified embodiment, for example in ceramics, where the connecting component 8' also supports one or more discrete components 13, such as capacitors, resistors, e t c. In this case, the connecting component 8' has another design, having transversely positioned side sections 10', 11', and possibly a hermetic closing area 14 in the area contacting the support member 1.

In both embodiments, the connecting component is designed having a peripherial edge 15, 15', with a large number of points of connections intended for the connection between the conductive pattern of the support member and the conductor of the connecting component. A bonding agent ensures the mechanical attachment of the connecting component 8, 8' to the support member 1, should the electrical connections themselves not have sufficient resistance.

By means of distributing - in a manner that is suitable for testing - connections, testing points and conductive paths between the support member 1 and the connecting component 8, a new way of testing IC chips can be realized. The principle is as follows.

Components, the chip and the cooler are mounted and connected to the support member 1. By not mounting the connecting component 8, parts of the IC can be kept electrically separated from the rest of the module (during a test) and the connecting points may be used to connect (for example by means of a probe card) stimuli-signals and to read output signals from the circuit. However, cooling, supply voltages, clock signals and other critical signals can be connected in a way which is normal for the construction. Several IC devices may be tested together.

At this stage it is relatively easy to exchange an IC, should it not function. When all the chips of interst have been tested - either each of them separately or in smaller groups - the connecting components may be mounted and connected and the completed module may be tested.

It is now much easier to test a completed module, since now only the internal connections in the module have to be tested and a control carried out to make sure that no chip has been broken during the process.

This way of testing allows for a measuring of those parameters which for different reasons cannot be measured on a (semi-conductor) wafer or on a chip, and which therefore cannot be controlled by the semi-conductor manufacturer.

The invention is not limited to the embodiments which are described above and shown in the drawings, but may be varied within the scope of the appended claims. For example, a single connecting component may bridge two or more IC circuits.

## Claims

1. Arrangement for integrated circuits (5) which are positioned on a support member (1) provided with a number of connections between components in an electric circuit, wherein the support member is provided with a heat conducting device (2, 4) that conducts heat away from at least one integrated circuit, **characterized in** that at least one part of the required connection paths in the area of said integrated circuit (5) is arranged in the form of a connecting component (8) which is supported by the support member and bridges said integrated circuit on one of its sides, and that one portion of the support member on the opposite side of the integrated circuit is provided with a heat conductor (4) forming part of said heat conducting device.

2. Arrangement according to claim 1, **characterized in** that said portion of the support member (1) is formed by one or more recesses (3) in the support member.

3. Arrangement according to claim 2, **characterized in** that said recess (3) in the support member (1) is a through recess and is filled with a body of a highly heat-conducting material, and that this body is connected to a cooling element.

4. Arrangement according to claim 1, **characterized in** that the connecting component (8) encapsules said integrated circuit (5).

5. Arrangement according to claim 4, **characterized in** that said encapsulation encompasses said circuit hermetically.

6. Arrangement according to claim 4, **characterized in** that said encapsulation forms an electric shielding of the integrated circuit.

7. Method for mounting of integrated circuits (5) on a support member (1) which comprises a number of connections between components in an electric circuit, **characterized by** the following steps:
mechanical mounting of the integrated circuit on the support member, including connection to a heat conductor (4),
testing of the integrated circuit by means of a connection of test signals from testing equipment to the integrated circuit, while at least some parts of said circuit are kept electrically separated from the other parts of the circuit, and
electrically finishing connection of the integrated circuit to said other parts of the circuit by means of mounting of a connecting component (8) on the support member, the connecting component bridging said integrated circuit.

## Patentansprüche

1. Anordnung für integrierte Schaltungen (5), die auf einem Halterungselement (1) positioniert sind, das mit einer Anzahl von Verbindungen Zwischenkomponenten in einer elektrischen Schaltung versehen ist, wobei das Halterungselement mit einer wärmeleitenden Einrichtung (2,4) versehen ist, die von wenigstens einer integrierten Schaltung Wärme wegleitet, dadurch gekennzeichnet, daß
wenigstens ein Teil der benötigten Verbindungspfade in dem Bereich der integrierten Schaltung (5) in der Form einer Verbindungskomponente (8) angeordnet ist, die durch das Halterungselement gehaltert wird, und die integrierte Schaltung auf einer ihrer Seiten überbrückt, und daß ein Abschnitt des Halterungselements auf der gegenüberliegenden Seite der integrierten Schaltung mit einem Wärmeleiter (4) versehen ist, der einen Teil der wärmeleitenden Einrichtung bildet.

2. Anordnung nach Anspruch 1,
dadurch gekennzeichnet, daß der Abschnitt des Halterungselements (1) durch eine oder mehrere Ausnehmungen (3) in dem Halterungselement gebildet ist.

3. Anordnung nach Anspruch 2,
dadurch gekennzeichnet, daß die Ausnehmung (3) in dem Halterungselement eine Durch-Ausnehmung ist, und mit einem Körper eines höchst wärmeleitenden Materials gefüllt ist, und daß dieser Körper mit einem Kühlelement verbunden ist.

4. Anordnung nach Anspruch 1,
dadurch gekennzeichnet, daß die Verbindungskomponente (8) die integrierte Schaltung verkapselt.

5. Anordnung nach Anspruch 4,
dadurch gekennzeichnet, daß die Verkapselung die Schaltung hermetisch einschließt.

6. Anordnung nach Anspruch 4,
dadurch gekennzeichnet, daß die Verkapselung eine elektrische Abschirmung der integrierten Schaltung bildet.

7. Verfahren zum Anbringen von integrierten Schaltungen (5) auf einem Halterungselement (1), welches eine Anzahl von Verbindungen zwischen Komponenten in einer elektrischen Schaltung umfaßt, gekennzeichnet durch die folgenden Schritte:
mechanisches Anbringen der integrierten Schaltung auf dem Halterungselement einschließlich einer Verbindung mit einem Wärmeleiter (4);
Testen der integrierten Schaltung mittels einer verbindung von Testsignalen von einer Testvorrichtung mit der integrierten Schaltung, während wenigstens einige Teile der Schaltung von den anderen Teilen der Schaltung elektrisch getrennt gehalten werden;
elektrisches Abschließen der Verbindung der integrierten Schaltung mit den anderen Teilen der Schaltung mitteln einer Anbringung einer Verbindungskomponente (8) auf dem Halterungselement, wobei die Verbindungskomponente die integrierte Schaltung überbrückt.

## Revendications

1. Montage pour des circuits intégrés (5) qui sont positionnés sur un élément de support (1) pourvu d'un certain nombre de connexions entre des composants dans un circuit électrique, dans lequel l'élément de support est pourvu d'un dispositif conducteur de la chaleur (2, 4) qui évacue par conduction de la chaleur d'au moins un circuit intégré, caractérisé en ce que au moins une partie des trajets de connexion demandés dans la zone dudit circuit intégré (5) est agencée sous la forme d'un composant (8) de connexion qui est supporté par l'élément de support et passe par-dessus ledit circuit intégré sur l'un de ses côtés, et en ce qu'une partie de l'élément de support sur le côté opposé du circuit intégré est pourvue d'un conducteur (4) de la chaleur faisant partie dudit dispositif de conduction de chaleur.

2. Montage selon la revendication 1, caractérisé en ce que ladite partie de l'élément de support (1) est formée par un ou plusieurs évidements (3) dans l'élément de support.

3. Montage selon la revendication 2, caractérisé en ce que ledit évidement (3) dans l'élément de support (1) est un évidement traversant et est rempli d'une masse de matière hautement conductrice de la chaleur, et en ce que cette masse est reliée à un élément de refroidissement.

4. Montage selon la revendication 1, caractérisé en ce que le composant (8) de connexion encapsule ledit circuit intégré (5).

5. Montage selon la revendication 4, caractérisé en ce que ladite encapsulation renferme ledit circuit de façon hermétique.

6. Montage selon la revendication 4, caractérisé en ce que ladite encapsulation forme un blindage électrique du circuit intégré.

7. Procédé pour le montage de circuits intégrés (5) sur un élément (1) de support qui comporte un certain nombre de connexions entre des composants d'un circuit électrique, caractérisé par les étapes suivantes :
le montage mécanique du circuit intégré sur l'élément de support, comprenant une connexion à un conducteur (4) de la chaleur,
l'essai du circuit intégré au moyen d'une connexion de signaux d'essai depuis un appareil d'essai au circuit intégré, tandis qu'au moins certaines parties dudit circuit sont maintenues séparées électriquement des autres parties du circuit, et
la connexion de finition électrique du circuit intégré auxdites autres parties du circuit au moyen du montage d'un composant (8) de connexion sur l'élément de support (1), le composant de connexion passant par-dessus ledit circuit intégré.
